# EUROPEAN PATENT APPLICATION

(11) **EP 4 818 726 A1**
(43) Date of publication of application: **07.10.2026**
(21) Application number: 26170658.4
(22) Date of filing: 02.04.2026
(51) Int. Cl.: G01R 31/392, G01R 31/396, B64D 27/357, G01R 31/00, G01R 31/389, H02J 7/50, H02J 7/96

(54) **BATTERY CELL CALIBRATION SYSTEM AND METHOD FOR AIRCRAFT BATTERIES**

(30) Priority: 04.04.2025 US 202519170849
(71) Applicant: Pratt & Whitney Canada Corp., Longueuil, Québec J4G 1A1 (CA)
(72) Inventor: GARIEPY, Raphael, (01BE5) Longueuil, J4G 1A1 (CA)
(74) Representative: Dehns

(57) **Abstract**

An assembly for an aircraft propulsion system (20) includes a battery (64), an electrical distribution system (66), a battery cell voltage sensor (132A), and a controller (28, 108). The battery (64) includes a plurality of battery cells (76). The electrical distribution system (66) is operable to electrically interconnect the battery (64) with a charging power source (62, 86). The battery cell voltage sensor (132A) is operable to measure a cell voltage of a first battery cell of the plurality of battery cells (76). The controller (28, 108) is connected in signal communication with the battery cell voltage sensor (132A) and the HVPDU (88). The controller (28, 108) configured to execute a charging sequence for the battery (64), determine a change in cell voltage of the first battery cell (76), determine a test cell resistance of the first battery cell (76), determine a change in resistance of the first battery cell (76), and identify a presence or an absence of an end-of-life condition of the first battery cell (76).

## Description

### TECHNICAL FIELD

This invention relates generally to aircraft electrical systems including batteries and, more particularly, to battery cell calibration systems and methods for identifying battery cell degradation.

### BACKGROUND OF THE ART

Propulsion system architectures for aircraft, such as hybrid-electric propulsion systems, may typically include one or more electrical assemblies configured to support various functions of the propulsion system and an associated aircraft. These electrical assemblies may frequently include batteries configured to provide electrical power for various electrical loads of the aircraft and its propulsion system(s). Various systems and methods for operating and monitoring these batteries are known. While these known systems and methods may be suitable for their intended purposes, there is always room in the art for improvement.

### SUMMARY

According to an aspect of the present invention, an assembly for an aircraft propulsion system includes a battery, an electrical distribution system, at least one battery cell voltage sensor, and a controller. The battery includes a plurality of battery cells. The electrical distribution system includes a high-voltage power distribution unit (HVPDU) operable to electrically interconnect the battery with a charging power source. The at least one battery cell voltage sensor is operable to measure a cell voltage of a first battery cell of the plurality of battery cells. The controller is connected in signal communication with the at least one battery cell voltage sensor and the HVPDU. The controller includes a processor connected in signal communication with a non-transitory memory storing instructions which, when executed by the processor, cause the processor to: execute a charging sequence for the battery, determine a change in cell voltage of the first battery cell by measuring, using the at least one battery cell voltage sensor, a pulse cell voltage of the first battery cell and an initial cell voltage of the first battery cell, the pulse cell voltage and the initial cell voltage measured during the charging sequence, the pulse cell voltage measured during application of an electrical power pulse to the battery, the initial cell voltage measured prior to application of the electrical power pulse, determine a test cell resistance of the first battery cell using the change in cell voltage, determine a change in resistance of the first battery cell using the test cell resistance and a baseline resistance of the first battery cell, and identify a presence or an absence of an end-of-life condition of the first battery cell by comparing the change in resistance to a resistance threshold value.

Optionally, and in accordance with the above, the assembly may further include an electric machine electrically connected with the electrical distribution system, and the instructions, when executed by the processor, may further cause the processor to execute the charging sequence for the battery using the electric machine in a generator mode of operation.

Optionally, and in accordance with any of the above, the instructions, when executed by the processor, may further cause the processor to execute the charging sequence for the battery by controlling the HVPDU to direct electrical power from the electric machine to the battery.

Optionally, and in accordance with any of the above, the assembly may further include an engine and a propulsor, the engine may include an engine output shaft, and the engine output shaft may be coupled with the propulsor and the electric machine.

Optionally, and in accordance with any of the above, the battery may include a plurality of battery strings formed by the plurality of battery cells, and the HVPDU may be operable to selectively electrically connect the plurality of battery strings together in parallel.

Optionally, and in accordance with any of the above, the instructions, when executed by the processor, may further cause the processor to execute the charging sequence for a subset at least one battery string of the plurality of battery strings of the battery, and the subset at least one battery string may include the first battery cell.

According to another aspect of the present invention, a method for calibrating a first battery cell of a battery for an aircraft propulsion system includes executing a charging sequence for the battery, the battery including a plurality of battery cells, the plurality of battery cells including the first battery cell, applying an electrical power pulse to the battery during the charging sequence, determining a change in cell voltage of the first battery cell by measuring a pulse cell voltage of the first battery cell and an initial cell voltage of the first battery cell, the pulse cell voltage and the initial cell voltage measured during the charging sequence, the pulse cell voltage measured during application of the electrical power pulse to the battery, the initial cell voltage measured prior to application of the electrical power pulse, determining a test cell resistance of the first battery cell using the change in cell voltage, determining a change in resistance of the first battery cell using the test cell resistance and a baseline resistance of the first battery cell, and identifying a presence or an absence of an end-of-life condition of the first battery cell by comparing the change in resistance to a resistance threshold value.

Optionally, and in accordance with the above, the method may further include replacing at least the first battery cell of the battery in response to identifying the presence of the end-of-life condition of the first battery cell.

Optionally, and in accordance with any of the above, executing the charging sequence may include charging the battery with a ground-based charger electrically connected with the battery.

Optionally, and in accordance with any of the above, executing the charging sequence may include charging the battery with an electric machine of the aircraft propulsion system electrically connected with the battery.

Optionally, and in accordance with any of the above, applying the electrical power pulse to the battery during the charging sequence may include operating the electric machine to form the electrical power pulse applied to the battery.

Optionally, and in accordance with any of the above, operating the electric machine to form the electrical power pulse may include operating the electric machine in a motoring mode of operation to form the electrical power pulse as a negative power pulse.

Optionally, and in accordance with any of the above, operating the electric machine to form the electrical power pulse may include operating the electric machine in a generating mode of operation to form the electrical power pulse as a positive power pulse.

Optionally, and in accordance with any of the above, the steps of determining the change in cell voltage, determining the test cell resistance, determining the change in resistance, and identifying the presence or the absence of the end-of-life condition may be performed for each battery cell of the plurality of battery cells.

Optionally, and in accordance with any of the above, the method may further include determining an energy storage capacity of the battery using the change in resistance determined for each of the plurality of battery cells.

According to another aspect of the present invention, there is provided an assembly for an aircraft propulsion system including a battery, a ground-based charger, an electrical distribution system, at least one battery cell voltage sensor, and a controller. The battery includes a plurality of battery cells. The electrical distribution system includes a high-voltage power distribution unit (HVPDU) operable to electrically interconnect the battery with the ground-based charger. The at least one battery cell voltage sensor is operable to measure a cell voltage of a first battery cell of the plurality of battery cells. The controller is connected in signal communication with the at least one battery cell voltage sensor and the HVPDU. The controller includes a processor connected in signal communication with a non-transitory memory storing instructions which, when executed by the processor, cause the processor to: execute a charging sequence for the battery by controlling the HVPDU to electrically connect the ground-based charger with the battery, determine a change in cell voltage of the first battery cell responsive to application of an electrical power pulse to the battery, determine a test cell resistance of the first battery cell using the change in cell voltage, determine a change in resistance of the first battery cell using the test cell resistance and a baseline resistance of the first battery cell, and identify a presence or an absence of an end-of-life condition of the first battery cell by comparing the change in resistance to a resistance threshold value.

Optionally, and in accordance with the above, the battery may include a plurality of battery strings formed by the plurality of battery cells, and the HVPDU may be operable to selectively electrically connect the plurality of battery strings together in parallel.

Optionally, and in accordance with any of the above, the instructions, when executed by the processor, may further cause the processor to execute the charging sequence for a subset at least one battery string of the plurality of battery strings of the battery, and the subset at least one battery string may include the first battery cell.

Optionally, and in accordance with any of the above, the assembly may further include an electric machine electrically connected with the electrical distribution system, and the instructions, when executed by the processor, may further cause the processor to initiate operation of the electric machine in a motoring mode of operation to form the electrical power pulse.

Optionally, and in accordance with any of the above, the assembly may further include an electric machine electrically connected with the electrical distribution system, and the instructions, when executed by the processor, may further cause the processor to initiate operation of the electric machine in a generating mode of operation to form the electrical power pulse.

The foregoing features and elements may be combined in various combinations without exclusivity, unless expressly indicated otherwise. For example, aspects and/or embodiments of the present invention may include any one or more of the individual features or elements disclosed above and/or below alone or in any combination thereof. These features and elements as well as the operation thereof will become more apparent in light of the following description and the accompanying drawings. It should be understood, however, the following description and drawings are intended to be exemplary in nature and non-limiting.

### DESCRIPTION OF THE DRAWINGS

FIG. 1 illustrates an aircraft including a propulsion system, in accordance with one or more embodiments of the present invention.
FIG. 2 schematically illustrates a cutaway, side view of an aircraft propulsion system, in accordance with one or more embodiments of the present invention.
FIG. 3 schematically illustrates a battery string for a battery, in accordance with one or more embodiments of the present invention.
FIG. 4 schematically illustrates an electrical assembly for an aircraft propulsion system, in accordance with one or more embodiments of the present invention.
FIG. 5 illustrates a block diagram depicting a control channel, in accordance with one or more embodiments of the present invention.
FIG. 6 illustrates a block diagram depicting a method for calibrating one or more battery cells of a battery for an aircraft propulsion system, in accordance with one or more embodiments of the present invention.
FIG. 7 illustrates a voltage response of a negative power pulse applied to the one or more battery cells, in accordance with one or more embodiments of the present invention.
FIG. 8 illustrates a voltage response of a positive power pulse applied to the one or more battery cells, in accordance with one or more embodiments of the present invention.
FIG. 9 illustrates an exemplary battery cell resistance over its operational life, in accordance with one or more embodiments of the present invention.

### DETAILED DESCRIPTION

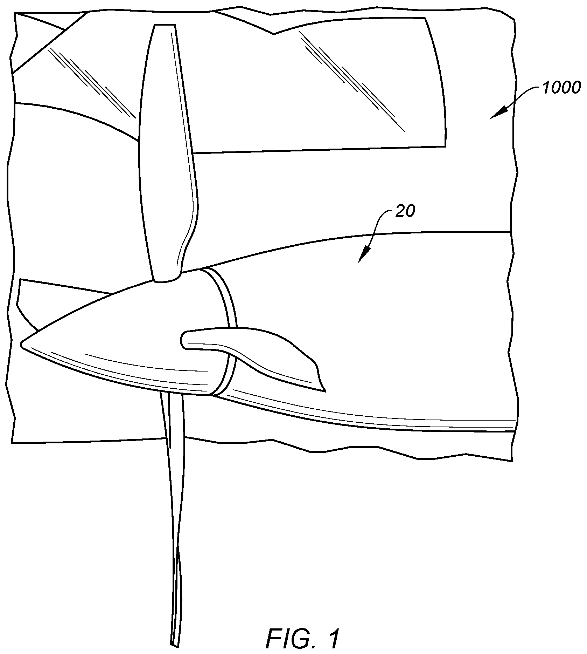

FIG. 1 illustrates an aircraft 1000 including at least one propulsion system 20. Briefly, the aircraft may be a fixed-wing aircraft (e.g., an airplane), a rotary-wing aircraft (e.g., a helicopter), a tilt-rotor aircraft, a tilt-wing aircraft, or another aerial vehicle. Moreover, the aircraft may be a manned aerial vehicle or an unmanned aerial vehicle (UAV, e.g., a drone).

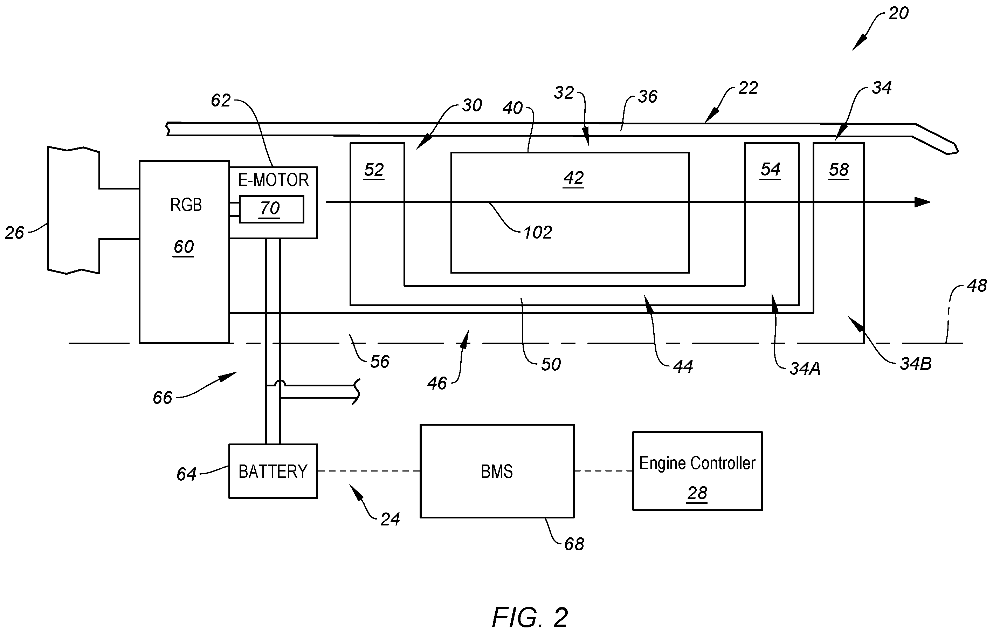

FIG. 2 schematically illustrates a cutaway, side view of the propulsion system 20. The propulsion system 20 of FIG. 2 includes an engine 22, an electrical assembly 24, a propulsor 26, and an engine controller 28. The engine 22 of FIG. 2 is configured as a turboprop gas turbine engine. However, the present invention is not limited to any particular configuration of gas turbine engine for the propulsion system 20, and examples of gas turbine engine configurations for the propulsion system 20 may include, but are not limited to, a turbofan engine, a turbojet engine, a propfan engine, or the like. Aspects of the present invention may be equally applicable to aircraft propulsion systems including other engine configurations such as, but not limited to, rotary engines, piston engines, and the like, or to electric aircraft propulsion systems (e.g., battery-electric propulsion systems, fuel-cell-electric propulsion systems, etc.). Aspects of the present invention may also be equally applicable to aircraft engines which are not part of a propulsion system, for example, an engine for an auxiliary power unit (APU).

The engine 22 of FIG. 2 includes a compressor section 30, a combustor section 32, a turbine section 34, and an engine static structure 36. The combustor section 32 includes a combustor 40 (e.g., an annular combustor). The combustor 40 forms a combustion chamber 42. The turbine section 34 includes a high-pressure turbine section 34A and a power turbine section 34B.

Components of the compressor section 30 and the turbine section 34 of FIG. 2 form a first rotational assembly 44 (e.g., a high-pressure spool) and a second rotational assembly 46 of the engine 22. The first rotational assembly 44 and the second rotational assembly 46 are mounted for rotation about a rotational axis 48 (e.g., an axial centerline) of the engine 22 relative to the engine static structure 36.

The first rotational assembly 44 includes a first shaft 50, a bladed compressor rotor 52 for the compressor section 30, and a bladed first turbine rotor 54 for the high-pressure turbine section 34A. The first shaft 50 interconnects the bladed compressor rotor 52 and the bladed first turbine rotor 54.

The second rotational assembly 46 of FIG. 2 includes a second shaft 56 (e.g., an engine output shaft) and a bladed second turbine rotor 58 for the power turbine section 34B. The second shaft 56 is connected to the bladed second turbine rotor 58. The second shaft 56 operably connects (e.g., directly or indirectly connects) the bladed second turbine rotor 58 with the propulsor 26. For example, the second shaft 56 of FIG. 2 is coupled with the propulsor 26 by a gear box 60 (e.g., a reduction gear box (RGB)). The gear box 60 includes a gear assembly (e.g., an epicyclic gear assembly) coupling the second shaft 56 and the propulsor 26. The gear assembly may be a reduction gear assembly configured to drive rotation of the propulsor 26 at a reduced rotational speed relative to the second shaft 56. Of course, the second shaft 56 may alternatively be directly connected to the propulsor 26 to drive the propulsor 26 at the same rotational speed as the second shaft 56.

The engine static structure 36 includes engine casings, cowlings, and other fixed (e.g., non-rotating) structures of the engine 22 which house and/or support components of the engine 22 such as, but not limited to, those of the compressor section 30, the combustor section 32, and the turbine section 34. The engine static structure 36 includes one or more bearing assemblies and/or gear trains configured to rotationally support and/or interconnect components of the first rotational assembly 44 and the second rotational assembly 46.

The electrical assembly 24 of FIG. 2 includes an electric machine 62, a battery 64, an electrical distribution system 66, and a battery management system 68.

The electric machine 62 is electrically connected to the electrical distribution system 66. The electric machine 62 may be configurable as an electric motor and/or an electric generator (e.g., an electric motor-generator). For example, during a motor mode of operation, the electric machine 62 may operate as the electric machine to convert electricity received from the electrical distribution system 66 (e.g., through a respective control unit) to mechanical power. By contrast, during a generator mode of operation, the electric machine 62 may operate as the electric generator to convert mechanical power received from the respective one of the rotational assemblies 44, 46 into electricity, for example, supplied to the electrical distribution system 66. The electric machine 62 of the present invention, however, are not limited to such exemplary operation. For example, the electric machine 62 may alternatively each be configured as a dedicated electric generator (e.g., without the electric machine functionality) or as a dedicated electric motor (e.g., without the electric generator functionality). The electric machine 62 includes a rotor 70. The rotor 70 is coupled to the propulsor 26 by the gear box 60. For example, the gear box 60 may couple both of the second shaft 56 and the rotor 70 to the propulsor 26 to facilitate driving rotation of the propulsor 26 with the bladed second turbine rotor 58 (e.g., via the second shaft 56), the electric machine 62 (e.g., the rotor 70), or a combination of the bladed second turbine rotor 58 and the electric machine 62. Additionally or alternatively, the gear box 60 may facilitate driving rotation of the rotor 70 by the second turbine rotor 58, for example, in a generator mode of operation of the electric machine 62. The electric machine 62 may additionally include a motor control unit configured to control electric power characteristics (e.g., frequency, voltage, current) supplied to the electric machine 62 (e.g., windings of the electric machine 62), for example, to control a rotation speed and/or torque of the rotor 70, or to control electric power characteristics of an electrical output of the electric machine 62 while generating.

The battery 64 is electrically connected to the electrical distribution system 66. The battery 64 is configured to selectively supply electrical power to the electrical distribution system 66 independently (e.g., as a single power source for the electrical assembly 24) or in combination with one or more other electrical power sources (e.g., an electrical generator). As will be discussed in further detail, the battery 64 may include a plurality of battery modules (e.g., battery packs), battery cells, and/or the like electrically connected together in series and/or parallel as necessary to configure the battery 64 with the desired electrical characteristics (e.g., voltage output, current output, storage capacity, etc.). The present invention is not limited to any particular configuration of the battery 64. The battery 64 (e.g., and its battery cells) may be configured as a rechargeable battery having a battery chemistry such as, but not limited to, lead acid, nickel cadmium (NiCd), nickel-metal hydride (Ni-MH), lithium-ion (Li-ion), lithium-polymer (Li-poly), lithium metal, and the like. The battery 64 may be disposed, for example, in the aircraft 1000 and/or its propulsion system 20.

During operation of the propulsion system 20 of FIG. 2, ambient air enters the propulsion system 20 through an air intake into and through a core flow path of the engine 22. The ambient air flow along the core flow path is compressed in the compressor section 30 and directed into the combustor 40. Fuel is injected into the combustor 40 (e.g., the combustion chamber 42) and mixed with the compressed air to provide a fuel-air mixture. This fuel-air mixture is ignited, and combustion products thereof flow through the high-pressure turbine section 34A and the power turbine section 34B and are exhausted from the propulsion system 20. The bladed first turbine rotor 54 and the bladed second turbine rotor 58 rotationally drive the first rotational assembly 44 and the second rotational assembly 46, respectively, in response to the combustion gas flow through the high-pressure turbine section 34A and the power turbine section 34B. The second rotational assembly 46 (e.g., the second shaft 56) may drive rotation of the propulsor 26, for example, through the gear box 60. The electric machine 62 may be selectively operated (e.g., by the engine controller 28) to drive rotation of the propulsor 26 independently or in combination with the engine 22 through the gear box 60.

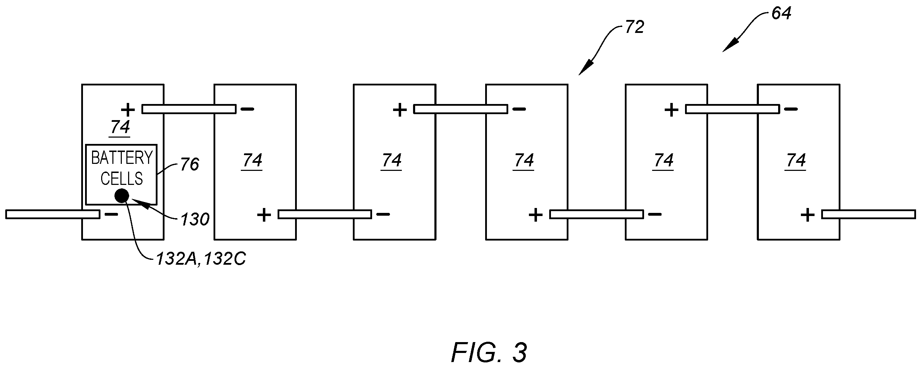

FIG. 3 schematically illustrates an exemplary battery string 72 of the battery 64. The battery string 72 of FIG. 3 includes a plurality of battery modules 74 (e.g., battery packs electrically connected in series to form the battery string 72. For example, each battery modules 74 of the battery string 72 may be electrically connected in series (e.g., positive to negative or negative to positive) to one or more other battery modules 74 of the battery string 72. The battery string 72 of FIG. 3 includes six (6) battery modules 74 electrically connected in series. The present invention, however, is not limited to any particular number of battery modules 74 for the battery string 72. Each battery module 74 may include a plurality of discrete battery cells 76 electrically connected together (e.g., using series and/or parallel electrical connections) to form the battery module 74, and as necessary to configure the battery string 72 with the desired electrical characteristics (e.g., voltage output, power output, etc.) for the battery 64. The battery cells 76 may be understood to as a smallest discrete unit of the battery 64 configured to convert chemical energy to electrical energy and vice versa (e.g., each of the battery cells 76 may include a cathode, an anode, and an electrolyte). The battery cells 76 may be configured as cylindrical cells, pouch cells, prismatic cells, and the like, and the present invention is not limited to any particular configuration of the battery cells 76.

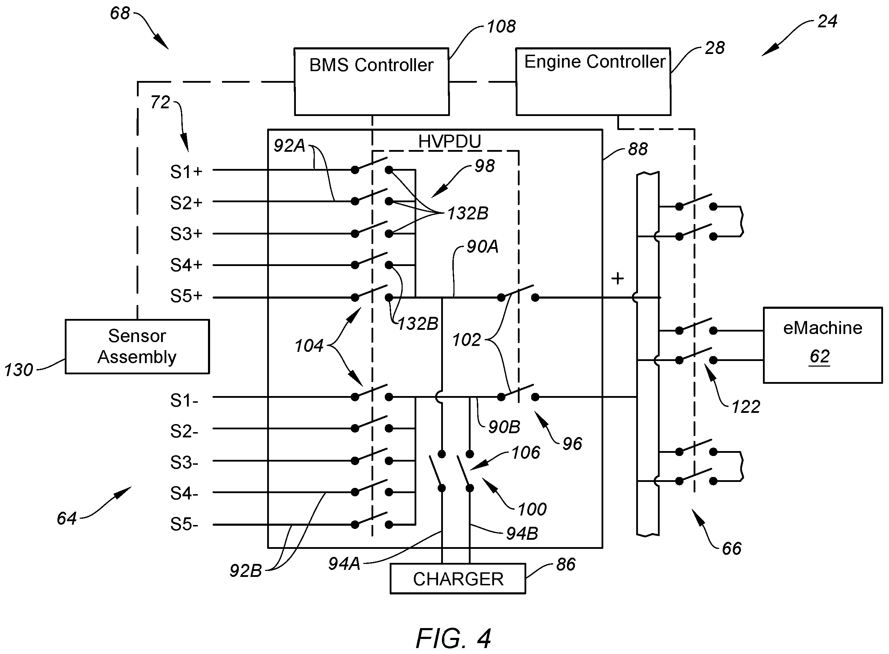

FIG. 4 schematically illustrates a portion of the electrical assembly 24 including the battery 64, the electrical distribution system 66, and the battery management system 68. The electrical assembly 24 is configured to supply electrical power to one or more electrical loads 84 (e.g., the electric machine 62) of the propulsion system 20 and/or the aircraft 1000 (see FIG. 1). The battery 64 of FIG. 4 includes a plurality of the battery strings 72 electrically connected together in parallel, for example, by the electrical distribution system 66. The plurality of battery strings 72 of FIG. 4 includes five (5) battery strings 72, S1-5 electrically connected together in parallel; however, the present invention is not limited to any particular quantity of battery strings 72 of the battery 64. The electrical assembly 24 further includes a charger 86 (e.g., a charging power source) which may be selectively electrically connected with the electrical distribution system 66 to supply electrical power to charge the battery 64 and/or to facilitate operation of the electrical loads 84. The charger 86 may typically be external to the aircraft 1000 (see FIG. 1) and ground based, and may be electrically connected with the electrical distribution system 66 by electrical cables or the like. The charger 86 may be configured as a bi-directional charger which is additionally operable supply electrical power from the battery 64 to a ground-based electrical distribution system and/or one or more electrical loads outside of the aircraft 1000. For example, the charger 86 may be operable to convert direct current (DC) electrical power from the battery 64 to an alternating current (AC) electrical power for a ground-based electrical distribution system.

The electrical distribution system 66 electrically interconnects components of the electrical assembly 24. The electrical distribution system 66 includes switchgear, cables, wires, breakers, switches, contactors, electrical power conditional and/or conversion (e.g., AC to DC or DC to AC conversion) components, and/or other electrical components to effect the transfer of electrical power between components of the electrical assembly 24. For example, the electrical distribution system 66 of FIG. 2 electrically connects the electric machine 62 (and other electrical loads 84 of the aircraft 1000 and/or the propulsion system 20) with the battery 64 and other electric power sources (e.g., an electrical generator) of the electrical assembly 24. The electrical distribution system 66 may additionally include one or more electrical power controllers, for example, to control a magnitude and/or direction of electrical current flow to components of the electrical assembly 24. The electrical distribution system 66 is configured to supply electrical power to the electrical loads 84 of the aircraft 1000, the propulsion system 20, and/or the engine 22.

The electrical distribution system 66 of FIG. 4 may include a high-voltage power distribution unit (HVPDU) 88. The HVPDU 88 of FIG. 4 includes a positive main battery line 90A, a negative main battery line 90B, a positive string line 92A and a negative string line 92B for each of the battery strings 72, a positive charger line 94A, and a negative charger line 94B. The present invention, however, is not limited to the foregoing exemplary configuration of the electrical distribution system 66 of FIG. 4 or its HVPDU 88. The main battery lines 90A, 90B electrically interconnect the battery strings 72 with the electrical loads 84 (e.g., at an electrical output of the HVPDU 88). The string battery lines 92A, 92B electrically connect each of the battery strings 72 with the main battery lines 90A, 90B. For example, the positive string lines 92A (e.g., S1+, S2+, S3+, S4+, S5+) are electrically connected together at a positive battery line 90A the negative string lines 92B (e.g., S1-, S2, S3-, S4-, S5-) electrically connected together at the negative battery line 90B to electrically connect the battery strings 72 in parallel. The charger lines 94A, 94B are configured to electrically interconnect the charger 86 with the main battery lines 90A, 90B when the charger 86 is electrically connected with the electrical distribution system 66. The HVPDU 88 further includes a main battery switch assembly 96 for the main battery lines 90A, 90B, a battery string switch assembly 98 for the string lines 92A, 92B, and a charger switch assembly 100 for the charger lines 94A, 94B.

The main battery switch assembly 96, the battery string switch assembly 98, and the charger switch assembly 100 of FIG. 4 each include electrical contactors configured to facilitate selective control of electrical current flow through the HVPDU 88, for example, along the main battery lines 90A, 90B, the string lines 92A, 92B, and the charger lines 94A, 94B. The contactors are selectively configurable (e.g., switchable) in and between a closed condition or an open condition to conduct or interrupt an electrical current flow, respectively. The contactors may include electrically-controlled relays or switches which may be controlled by an electrical control signal to position the respective contactors in the open condition or the closed condition. The present invention, switch assemblies 96, 98, 100, however, are not limited to electrical contactors and other electrical power interruption devices, breakers, and switches may alternatively be used. The main battery switch assembly 96, the battery string switch assembly 98, and the charger switch assembly 100 of FIG. 4 include main battery contactors 102, string contactors 104, and charger contactors 106 on each of the main battery lines 90A, 90B, the string lines 92A, 92B, and the charger lines 94A, 94B, respectively.

The battery management system 68 includes a BMS controller 108. As shown in FIG. 4, the BMS controller 108 may be connected in electrical (e.g., signal) communication with the HVPDU 88 including each of the main battery contactors 102 and each of the string contactors 104 to control positions of the main battery contactors 102 and the string contactors 104 in a closed position or an open position.

The engine controller 28 may control operating parameters of the engine 22 including, but not limited to, fuel flow, stator vane position (e.g., variable compressor inlet guide vane (IGV) position), compressor air bleed valve position, shaft (e.g., first shaft 50 and/or second shaft 56) torque and/or rotation speed, etc. so as to control an engine power or performance of the propulsion system 20. Electrical contactors for the electrical loads 84, such as electric machine contactors 122 for the electric machine 62, may be controlled by the engine controller 28 to facilitate operation of the electric machine 62 as an electric motor for propulsion or as an electric generator for supplying electrical power to the electrical distribution system 66. In some embodiments, the engine controller 28 may be part of a full authority digital engine control (FADEC) system for the propulsion system 20 and its engine 22. The engine controller 28 receives signals from the BMS controller 108 to facilitate operation and control of the engine 22 and the electrical assembly 24 by the engine controller 28 or by the engine controller 28 and the BMS controller 108 in combination.

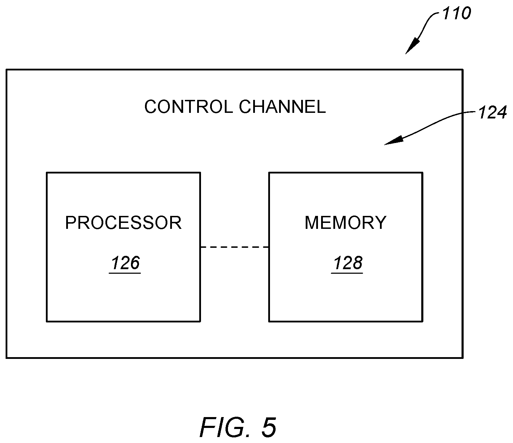

Referring briefly to FIG. 5, the engine controller 28 and the BMS controller 108 may each include at least one control channel 110. Each of the control channels 110 includes a discrete processing system 124. The processing system 124 includes a processor 126 connected in signal communication with memory 128. The processor 126 may include any type of computing device, computational circuit, processor(s), central processing unit (CPU), graphics processing unit (GPU), computer, or the like capable of executing a series of instructions that are stored in memory 128. Instructions can be directly executable or can be used to develop executable instructions. For example, instructions can be realized as executable or non-executable machine code or as instructions in a high-level language that can be compiled to produce executable or non-executable machine code. Further, instructions also can be realized as or can include data. Computer-executable instructions also can be organized in any format, including routines, subroutines, programs, data structures, objects, modules, applications, applets, functions, etc. The instructions may include an operating system, and/or executable software modules such as program files, system data, buffers, drivers, utilities, and the like. The executable instructions may apply to any functionality described herein to enable the processing system 124 and its processor 126 to accomplish the same algorithmically and/or coordination of electrical assembly 24 components including, but not limited to, the electric machine 62, the battery 64, the electric distribution system 66, and the battery management system 68. The memory 128 may include a single memory device or a plurality of memory devices (e.g., a computer-readable storage device that can be read, written, or otherwise accessed by a general purpose or special purpose computing device, including any processing electronics and/or processing circuitry capable of executing instructions). The present invention is not limited to any particular type of memory device, which may be non-transitory, and may include read-only memory, random access memory, volatile memory, non-volatile memory, static memory, dynamic memory, flash memory, cache memory, volatile or non-volatile semiconductor memory, optical disk storage, magnetic disk storage, magnetic tape, other magnetic storage devices, or any other medium capable of storing one or more instructions, and/or any device that stores digital information. The memory device(s) may be directly and/or indirectly coupled to the respective one of the engine controller 28 or the BMS controller 108. The processing system 124 may include, or may be in communication with, a user interface including one or more inputs devices and/or one or more output devices, for example, an input device that enables a user to enter data and/or instructions and an output device configured to display information (e.g., a visual display or a printer), or to transfer data, etc. Communications between the processing system 124 and external electrical or electronic devices may be via a hardwire connection or via a wireless connection. A person of skill in the art will recognize that portions of the processing system 124 may assume various forms (e.g., digital signal processor, analog device, etc.).

The battery management system 68 and its BMS controller 108 are configured to monitor conditions of the battery 64 such as, but not limited to, charging parameters, discharge parameters, state of charge, state of health, temperature, voltage, current, battery faults, arc discharges, and the like, to facilitate operation and control of the electrical assembly 24 and the battery 64. The battery management system 68 includes a battery sensor assembly 130 connected in signal communication with the BMS controller 108. The battery sensor assembly 130 includes battery cell voltage sensors 132A, battery current sensors 132B, and battery temperature sensors 132C. Each of the battery cell voltage sensors 132A is configured to measure a cell voltage for a respective one of the battery cells 76 of the battery 64. The battery current sensors 132B are configured to measure electrical currents of the battery 64, for example, a current flow along the battery strings 72 and/or the battery modules 74 (e.g., to determine a representative current flow through the battery cells 76 of the battery strings 72 and/or battery modules 74). The battery temperature sensors 132C are configured to measure temperatures of the battery cells 76. For example, each of the battery temperature sensors 132C may be configured to measure a cell temperature for a respective one of the battery cells 76 of the battery 64. Alternatively, each of the battery temperature sensors 132C may be configured to measure a representative temperature for a group of the battery cells 76 (e.g., an average temperature for an adjacent grouping of cells).

Operating characteristics of a battery (e.g., the battery 64) such as, but not limited to, battery cell internal resistance and energy storage capacity, may typically vary throughout an operational life of the battery. For example, battery cell internal resistances of the battery may gradually increase while the energy storage capacity of these battery cells may decrease. As the energy storage capacities of the battery cells of a battery decrease, the performance of the battery may correspondingly diminish. For batteries which facilitate propulsion for an aircraft by an aircraft propulsion system, this diminishing performance may yield reduced aircraft range and/or flight capabilities, which diminished performance must be accounted for in operation of the propulsion system 20 and associated aircraft 1000. The energy storage capacity of the battery over its operational life may be estimated; however, this approach risks overestimating or underestimating the actual energy storage capacity of the battery. Moreover, estimates on the remaining energy storage capacity of the battery may not accurately indicate individual battery cell degradations or when a battery or a portion of the battery (e.g., a battery cell, a battery module, etc.) should be removed from service (e.g., replaced).

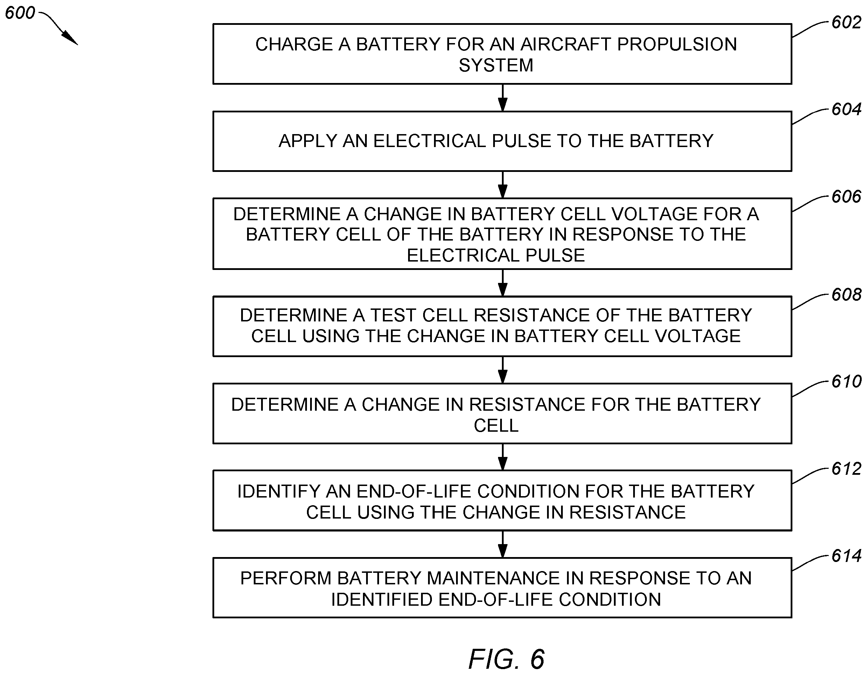

Referring to FIGS. 3-6, a method 600 for calibrating one or more battery cells of a battery for an aircraft propulsion system is provided. FIG. 6 illustrates a flowchart for the method 600. The method 600 is described herein for the propulsion system 20 and its engine 22, electrical assembly 24, and engine controller 28. The present invention method 600, however, is not limited to use with the particular propulsion system 20 described herein. The control channels 110 (e.g., the processor 126) of the engine controller 28 and/or the BMS controller 108 may execute instructions stored in the memory 128, thereby causing the respective controller 28, 108 to perform and/or control one or more steps or portions of steps of the method 600. Unless otherwise noted herein, it should be understood that the steps of method 600 are not required to be performed in the specific sequence in which they are discussed below and, in some embodiments, the steps of method 600 may be performed separately or simultaneously.

Step 602 includes charging the battery 64. In particular, step 602 may include charging one or more of the battery strings 72 through an executed charging sequence. The BMS controller 108 may execute the charging sequence for the battery 64 (e.g., one or more of the battery strings 72) by controlling and/or monitoring operating parameters of the battery 64 and/or the HVPDU 88 such as, but not limited to, voltages, currents, battery temperatures, contactor 102, 104, 106 positions, and the like. For example, the charger 86 may supply electrical power to the battery 64 through the HVPDU 88 to charge the battery 64 while the aircraft 1000 is in a grounded condition. Alternatively, for example, the electric machine 62, in a generating mode of operation (e.g., operating as a charging power source), may be driven (e.g., by the second rotational assembly 46) to generate and supply electrical power to the battery 64 through the HVPDU 88 (e.g., in a grounded or airborne condition of the aircraft 1000). Still alternatively, for example, the battery 64 may be charged from another electrical charging power source such as, but not limited to, an auxiliary power unit (APU) or another propulsion system of the aircraft 1000.

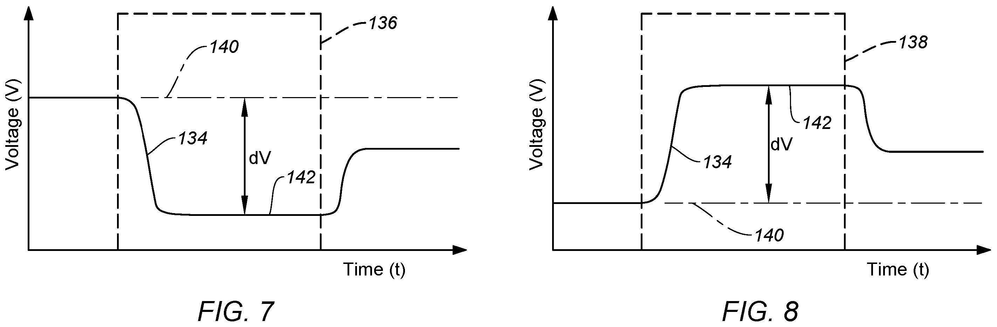

Step 604 includes applying one or more electrical power pulses to the battery 64 while executing the charging sequence for the battery 64, as described for step 602. FIGS. 7 and 8 illustrate exemplary battery cell voltages 134 for one of the battery cells 76 before, during, and after application of an electrical power pulse to the battery 64. The electrical power pulses applied to the battery 64 may be negative power pulses (e.g., a discharge pulse) or positive power pulses (e.g., a charge pulse). FIG. 7 illustrates a negative power pulse 136 applied to the battery 64. Step 604 may include applying the negative power pulse 136 to the battery 64 by supplying electrical power from the battery 64 to an electrical load of the electrical distribution system 66 such as, but not limited to, the electric machine 62. For example, the BMS controller 108 may initiate formation of the electrical power pulse by communicating with the engine controller 28 to prompt the engine controller 28 to (e.g., briefly) energize the electric machine 62. Alternatively, the charger 86, configured as a bi-directional charger, may operate to briefly supply electrical power from the battery 64 to a ground-based electrical distribution system. FIG. 8 illustrates a positive power pulse 138 applied to the battery 64. Step 604 may include applying the positive power pulse 138 to the battery 64 by increasing electrical power supplied to the battery 64 (e.g., from the charger 86 and/or the electric machine 62) while charging the battery 64. The negative power pulse 136 and the positive power pulse 138 may be characterized by a predetermined electrical power value (e.g., a positive or negative power value) applied to the battery 64. This predetermined electrical power value may be used for each application of the method 600 for a given battery 64 to facilitate consistent calibrating of the battery cells 76 over the operational life of the battery 64. The electrical power pulse 136, 138 applied to the battery 64 may be a function of a direct current (DC) supplied to or from the battery 64. Alternatively, application of the electrical power pulse 136, 138 may include application of an alternating current (AC) to the battery 64, for example, at a predetermined AC frequency (e.g., greater than 1 kHz).

Step 606 includes determining a change in cell voltage (dV) for one, more than one, or each of the battery cells 76 of the battery 64 in response to application of the electrical power pulse 136, 138 to the battery 64. Step 606 includes measuring (e.g., using the battery cell voltage sensors 132) an initial cell voltage 140 of the battery cell 76 prior to (e.g., immediately prior to) application of the electrical power pulse 136, 138 and a pulse cell voltage 142 of the battery cell 76 during application of the electrical power pulse 136, 138.

Step 608 includes determining a test cell resistance (R) for one, more than one, or each of the battery cells 76 of the battery 64 using the change in cell voltage (dV) measured for each respective one of the battery cells 76. The test cell resistance (R) may be determined as a function of the change in cell voltage (dV) and electrical current (I) (e.g., measured using the current sensors 132B) and corrected for cell temperature (e.g., measured using the temperature sensors 132C). The test cell resistance (R) may be calculated or otherwise determined (e.g., using lookup tables, a battery cell resistance map, etc.) by the BMS controller 108 (or another processing system).

Step 610 includes determining a change in resistance (dR) for one, more than one, or each of the battery cells 76 of the battery 64 relative to a baseline resistance (e.g., a beginning-of-life resistance) of each respective one of the battery cells 76. The change in resistance (dR) may be determined using the different between the test cell resistance and the respective baseline resistance for each given one of the battery cells 76. The baseline resistance for the battery cells 76 may be determined, for example, by the battery manufacturer or upon installation on the aircraft 1000. The change in resistance (dR) of each of the tested battery cells 76 may be stored in memory 128 (e.g., of the engine controller 28, the BMS controller 108, or another aircraft computer system). Additionally or alternatively, the change in resistance (dR) of each of the tested battery cells 76 may be transmitted to one or more off-aircraft computer system. The stored values of the change in resistance (dR) for the battery cells 76 may facilitate data trending analysis and battery maintenance planning. The stored values of the change in resistance (dR) for the battery cells 76 may also be used to approximate a remaining energy storage capacity of the battery 64, for example, using lookup tables, battery models, or the like.

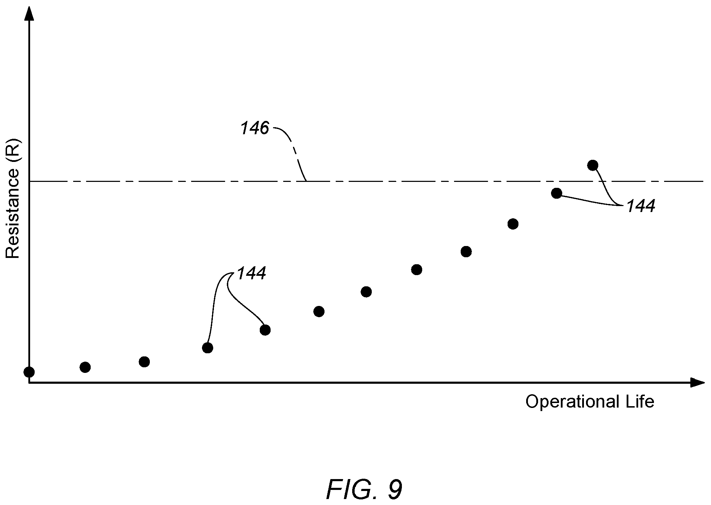

Step 612 includes identifying a presence or an absence of an end-of-life condition for one, more than one, or each of the battery cells 76 of the battery 64 using the change in change in resistance (dR) of each respective one of the battery cells 76. For example, the change in resistance (dR) may be compared to a resistance threshold selected to indicate the end-of-life condition for a given one of the battery cells 76. As shown in FIG. 9, values of the change in resistance (dR) 144 for a given one of the battery cells 76 may be stored and tracked over the operational life of the battery cells 76. The change in resistance values (dR) may be expected to gradually increase over the operational life of the battery cells 76, as shown in FIG. 9. Where the determined change in resistance (dR) value of a given one of the battery cells 76 is less than a resistance threshold 146, the absence of the end-of-life condition may be identified (e.g., by the BMS controller 1080 for the battery cell 76. When the determined change in resistance (dR) value 144 of a given one of the battery cells 76 is greater than (e.g., increases above) the resistance threshold 146, the presence of the end-of-life condition may be identified (e.g., by the BMS controller 1080 for the battery cell 76.

Step 614 includes replacing a battery module 74, a battery string 72, the battery 64, or another line replaceable unit (LRU) of the battery 64 in response to identifying the presence of the end-of-life condition for one or more battery cells 76 of the battery 64. For example, the battery module 74, battery string 72, or other LRU determined as having a one or more battery cells 76 at an identified end-of-life-condition may be replaced.

While the principles of the invention have been described above in connection with specific apparatuses and methods, it is to be clearly understood that this description is made only by way of example and not as limitation on the scope of the invention. Specific details are given in the above description to provide a thorough understanding of the embodiments. However, it is understood that the embodiments may be practiced without these specific details.

It is noted that the embodiments may be described as a process which is depicted as a flowchart, a flow diagram, a block diagram, etc. Although any one of these structures may describe the operations as a sequential process, many of the operations can be performed in parallel or concurrently. In addition, the order of the operations may be rearranged. A process may correspond to a method, a function, a procedure, a subroutine, a subprogram, etc.

The singular forms "a," "an," and "the" refer to one or more than one, unless the context clearly dictates otherwise. For example, the term "comprising a specimen" includes single or plural specimens and is considered equivalent to the phrase "comprising at least one specimen." The term "or" refers to a single element of stated alternative elements or a combination of two or more elements unless the context clearly indicates otherwise. As used herein, "comprises" means "includes." Thus, "comprising A or B," means "including A or B, or A and B," without excluding additional elements.

It is noted that various connections are set forth between elements in the present description and drawings (the contents of which are included in this invention by way of reference). It is noted that these connections are general and, unless specified otherwise, may be direct or indirect and that this specification is not intended to be limiting in this respect. Any reference to attached, fixed, connected, or the like may include permanent, removable, temporary, partial, full and/or any other possible attachment option.

The terms "substantially," "about," "approximately," and other similar terms of approximation used throughout this patent application are intended to encompass variations or ranges that are reasonable and customary in the relevant field. These terms should be construed as allowing for variations that do not alter the basic essence or functionality of the invention. Such variations may include, but are not limited to, variations due to manufacturing tolerances, materials used, or inherent characteristics of the elements described in the claims, and should be understood as falling within the scope of the claims unless explicitly stated otherwise.

No element, component, or method step in the present invention is intended to be dedicated to the public regardless of whether the element, component, or method step is explicitly recited in the claims. As used herein, the terms "comprise", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various inventive aspects, concepts and features of the inventions may be described and illustrated herein as embodied in combination in the exemplary embodiments, these various aspects, concepts, and features may be used in many alternative embodiments, either individually or in various combinations and sub-combinations thereof. Unless expressly excluded herein all such combinations and sub-combinations are intended to be within the scope of the present application. Still further, while various alternative embodiments as to the various aspects, concepts, and features of the inventions--such as alternative materials, structures, configurations, methods, devices, and components, and so on--may be described herein, such descriptions are not intended to be a complete or exhaustive list of available alternative embodiments, whether presently known or later developed. Those skilled in the art may readily adopt one or more of the inventive aspects, concepts, or features into additional embodiments and uses within the scope of the present application even if such embodiments are not expressly disclosed herein. For example, in the exemplary embodiments described above within the Detailed Description portion of the present specification, elements may be described as individual units and shown as independent of one another to facilitate the description. In alternative embodiments, such elements may be configured as combined elements.

## Claims

1. An assembly for an aircraft propulsion system (20), the assembly comprising:
a battery (64) including a plurality of battery cells (76);
an electrical distribution system (66) including a high-voltage power distribution unit, HVPDU, (88) operable to electrically interconnect the battery (64) with a charging power source (62, 86);
at least one battery cell voltage sensor (132A) operable to measure a cell voltage of a first battery cell of the plurality of battery cells (76); and
a controller (28, 108) connected in signal communication with the at least one battery cell voltage sensor (132A) and the HVPDU (88), the controller (28, 108) including a processor (126) connected in signal communication with a non-transitory memory (128) storing instructions which, when executed by the processor (126), cause the processor (126) to:
execute a charging sequence for the battery (64);
determine a change in cell voltage of the first battery cell (76) by measuring, using the at least one battery cell voltage sensor (132A), a pulse cell voltage (142) of the first battery cell (76) and an initial cell voltage (140) of the first battery cell (76), the pulse cell voltage (142) and the initial cell voltage (140) measured during the charging sequence, the pulse cell voltage (142) measured during application of an electrical power pulse (136, 138) to the battery (64), the initial cell voltage (140) measured prior to application of the electrical power pulse (136, 138);
determine a test cell resistance of the first battery cell (76) using the change in cell voltage;
determine a change in resistance of the first battery cell (76) using the test cell resistance and a baseline resistance of the first battery cell (76); and
identify a presence or an absence of an end-of-life condition of the first battery cell (76) by comparing the change in resistance to a resistance threshold value (146).

2. The assembly of claim 1, further comprising an electric machine (62) electrically connected with the electrical distribution system (66), and the instructions, when executed by the processor (126), further cause the processor (126) to execute the charging sequence for the battery (64) using the electric machine (62) in a generator mode of operation.

3. The assembly of claim 2, wherein the instructions, when executed by the processor (126), further cause the processor (126) to execute the charging sequence for the battery (64) by controlling the HVPDU (88) to direct electrical power from the electric machine (62) to the battery (64).

4. The assembly of claim 2 or 3, further comprising an engine (22) and a propulsor (26), the engine (22) including an engine output shaft, the engine output shaft coupled with the propulsor (26) and the electric machine (62).

5. A method (600) for calibrating a first battery cell (76) of a battery (64) for an aircraft propulsion system (20), the method (600) comprising:
executing a charging sequence for the battery (64), the battery (64) including a plurality of battery cells (76), the plurality of battery cells (76) including the first battery cell;
applying an electrical power pulse (136, 138) to the battery (64) during the charging sequence;
determining a change in cell voltage of the first battery cell (76) by measuring a pulse cell voltage (142) of the first battery cell (76) and an initial cell voltage (140) of the first battery cell (76), the pulse cell voltage (142) and the initial cell voltage (140) measured during the charging sequence, the pulse cell voltage (142) measured during application of the electrical power pulse (136) to the battery (64), the initial cell voltage (140) measured prior to application of the electrical power pulse (136);
determining a test cell resistance of the first battery cell (76) using the change in cell voltage;
determining a change in resistance of the first battery cell (76) using the test cell resistance and a baseline resistance of the first battery cell (76); and
identifying a presence or an absence of an end-of-life condition of the first battery cell (76) by comparing the change in resistance to a resistance threshold value (146).

6. The method (600) of claim 5, further comprising replacing at least the first battery cell (76) of the battery (64) in response to identifying the presence of the end-of-life condition of the first battery cell (76).

7. The method (600) of claim 5 or 6, wherein executing the charging sequence includes charging the battery (64) with a ground-based charger (86) electrically connected with the battery (64).

8. The method (600) of claim 5 or 6, wherein executing the charging sequence includes charging the battery (64) with an electric machine (62) of the aircraft propulsion system (20) electrically connected with the battery (64).

9. The method (600) of claim 8, wherein applying the electrical power pulse (136, 138) to the battery (64) during the charging sequence includes operating the electric machine (62) to form the electrical power pulse (136, 138) applied to the battery (64).

10. The method (600) of claim 9, wherein operating the electric machine (62) to form the electrical power pulse (136, 138) includes:
operating the electric machine (62) in a motoring mode of operation to form the electrical power pulse as a negative power pulse (136); or
operating the electric machine (62) in a generating mode of operation to form the electrical power pulse as a positive power pulse (138).

11. The method (600) of any of claims 5 to 10, wherein the steps of determining the change in cell voltage, determining the test cell resistance, determining the change in resistance, and identifying the presence or the absence of the end-of-life condition are performed for each battery cell of the plurality of battery cells (76), and wherein, optionally, the method (600) further comprises determining an energy storage capacity of the battery (64) using the change in resistance determined for each of the plurality of battery cells (76).

12. An assembly for an aircraft propulsion system (20), the assembly comprising:
a battery (64) including a plurality of battery cells (76);
a ground-based charger (86);
an electrical distribution system (66) including a high-voltage power distribution unit, HVPDU, (88) operable to electrically interconnect the battery (64) with the ground-based charger (86);
at least one battery cell voltage sensor (132A) operable to measure a cell voltage of a first battery cell of the plurality of battery cells (76); and
a controller (28, 108) connected in signal communication with the at least one battery cell voltage sensor (132A) and the HVPDU (88), the controller (28, 108) including a processor (126) connected in signal communication with a non-transitory memory (128) storing instructions which, when executed by the processor (126), cause the processor (126) to:
execute a charging sequence for the battery (64) by controlling the HVPDU (88) to electrically connect the ground-based charger (86) with the battery (64);
determine a change in cell voltage of the first battery cell (76) responsive to application of an electrical power pulse (136, 138) to the battery (64);
determine a test cell resistance of the first battery cell (76) using the change in cell voltage;
determine a change in resistance of the first battery cell (76) using the test cell resistance and a baseline resistance of the first battery cell (76); and
identify a presence or an absence of an end-of-life condition of the first battery cell (76) by comparing the change in resistance to a resistance threshold value (146).

13. The assembly of claim 12, further comprising an electric machine (62) electrically connected with the electrical distribution system (66), and the instructions, when executed by the processor (126), further cause the processor (126) to:
initiate operation of the electric machine (62) in a motoring mode of operation to form the electrical power pulse (136); or
initiate operation of the electric machine (62) in a generating mode of operation to form the electrical power pulse (138).

14. The assembly of any of claims 1 to 4, 12, or 13, wherein the battery (64) includes a plurality of battery strings (72) formed by the plurality of battery cells (76), and the HVPDU (88) is operable to selectively electrically connect the plurality of battery strings (72) together in parallel.

15. The assembly of claim 14, wherein the instructions, when executed by the processor (126), further cause the processor (126) to execute the charging sequence for a subset at least one battery string (72) of the plurality of battery strings (72) of the battery (64), and the subset at least one battery string (72) includes the first battery cell (76).
